# EUROPÄISCHE PATENTSCHRIFT

(11) **EP 0 714 555 B1**
(45) Veröffentlichungstag und Bekanntmachung des Hinweises auf die Patenterteilung: **17.03.1999**
(21) Anmeldenummer: 95917288.3
(22) Anmeldetag: 10.05.1995
(51) Int. Cl.: H01L 25/07, F02P 7/02

(54) **HOCHSPANNUNGSKIPPDIODE**
HIGH-VOLTAGE BREAKOVER DIODE
DIODE A QUATRE COUCHES HAUTE TENSION

(30) Priorität: 17.05.1994 DE 4417164
(43) Veröffentlichungstag der Anmeldung: 05.06.1996
(73) Patentinhaber: ROBERT BOSCH GMBH, 70442 Stuttgart (DE)
(72) Erfinder: VOGEL, Manfred, D-71254 Ditzingen (DE); HERDEN, Werner, D-70839 Gerlingen (DE); KONRAD, Johann, D-71732 Tamm (DE); SPITZ, Richard, D-72766 Reutlingen (DE); GOEBEL, Herbert, D-72766 Reutlingen (DE)
(86) Internationale Anmeldenummer: DE9500615
(87) Internationale Veröffentlichungsnummer: WO9531827

(56) Entgegenhaltungen:
- WO-A-88/00395
- WO-A-89/11734
- DE-A- 4 032 131
- US-A- 3 373 335

## Beschreibung

### Stand der Technik

Die Erfindung geht aus von einer Hochspannungskippdiode nach der Gattung des Hauptanspruchs. Es ist schon eine solche Hochspannungskippdiode aus der DE-OS 40 32 131 bekannt, bei der eine Vielzahl von in Reihe geschalteten Kippdioden eine Hochspannungskippdiode darstellen. Die einzelnen Halbleiterelemente sind hierbei in einer Kaskadenschaltung übereinander gestapelt und anschließend ist der Umfang dieses Halbleiterstapels mit einem lichtdurchlässigen Isolator überzogen. Mit einer solchen Hochspannungskippdiode können sehr exakt hohe Spannungen geschaltet werden, so daß diese Hochspannungskippdiode als Zündspannungsverteiler bei einer ruhenden Hochspannungsverteilung einsetzbar ist. Dabei bilden die am Umfang der Kaskade liegenden pn-Übergänge lichtempfliche Zonen, die von lichtemittierenden Elementen so angesteuert werden, daß sie zu einem vorgegebenen Zeitpunkt durchschalten.

WO-A-8 902 527 offenbart auch einen Hochspannungsschalter.

WO-A-8 800 395 beschreibt eine stapelförmige Diodenanordnung.

### Vorteile der Erfindung

Die erfindungsgemäße Anordnung mit den kennzeichnenden Merkmalen des Hauptanspruchs hat demgegenüber den Vorteil, daß für die Herstellung der Kippdiodenkaskade herkömmliche in Planartechnik hergestellte Kippdiodenchips verwendet werden können. Weiterhin hat diese Anordnung den Vorteil, daß die hochsperrenden pn-Übergänge nicht am Umfang des Kippdiodenstapels freiliegen sondern an der Chipoberseite mit Siliziumoxid (SiO2) passiviert sind und somit kein ungewolltes Schalten der Kippdiode durch undefinierte Oberflächenzustände am Rand, die sich durch Sägeschäden ergeben können, erfolgen kann, wodurch eine hohe Ausbeute des Siliziumwafers und eine hohe Schaltgenauigkeit jedes Kippdiodenchips gegeben ist. Mit der Isolation von Kippdiodenchip zu Kippdiodenchip durch eine elektrisch isolierende Kunststoffschicht und der mechanischen Verbindung und elektrischen Kontaktierung mittels einer Verbindungsschicht ist eine zusätzliche mechanische Festigkeit auch bei kleiner Kathodenfläche gegeben. Damit ist es möglich, Kippdiodenchips mit kleiner Chipfläche zu verwenden, wodurch niedrigere Chipkosten entstehen, und gleichzeitig eine hohe mechanische Festigkeit zu gewährleisten.

Durch die in den Unteransprüchen aufgeführten Maßnahmen sind vorteilhafte Weiterbildungen und Verbesserungen der im Hauptanspruch angegebenen Hochspannungskippdiode möglich. Besonders vorteilhaft ist, daß die elektrisch isolierende Kunststoffschicht photostrukturierbar ist, daß sie im Siebdruckverfahren aufbringbar ist und anschließend die notwendigen Ausparungen im Bereich der Elektroden und der Sägegräben photolitographisch herstellbar sind. Weiterhin ist es vorteilhaft als elektrisch isolierende Kunststoffschischt eine Polyimidschicht zu verwenden. Damit ist es möglich eine Lichtleitung vom Umfang der Hochspannungskippdiode an die lichtempfindlichen pn-Übergänge, die jeweils an der Kippdiodenchipoberseite freiliegen, zu gewährleisten.

Es ist weiterhin von Vorteil, daß zur Herstellung einer Hochspannungskippdiode zunächst ein Siliziumwafer mit einer Vielzahl von einzelnen Kippdioden hergestellt werden kann und anschließend einzelne Wafer zu einem Stapel übereinandergeschichtet werden, so daß durch einfaches Heraus sägen der Hochspannungskippdiode diese sehr kostengünstig und einfach herstellbar ist.

Weiterhin ist es vorteilhaft, die mechanische Verbindung und elektrische Kontaktierung der einzelnen Kippdiodenwafer untereinander mittels eines leitfähigen Klebers, beispielsweise eines metallhaltigen Polyimidklebers herzustellen, wobei es vorteilhaft ist, einen vorhärtbaren Kleber zu verwenden, da dieser im Siebdruckverfahren aufgebracht werden kann und für ein besseres Handling vorgehärtet wird, so daß nach der Verbindung der einzelnen Kippdiodenchips dieser Kleber nur noch ausgehärtet werden muß.

Letztendlich kann für die mechanische und elektrische Verbindung der einzelnen Kippdiodenchips auch eine Lotverbindung vorgesehen werden, diese ist unter Umständen kostengünstiger als der Kleber.

### Zeichnung

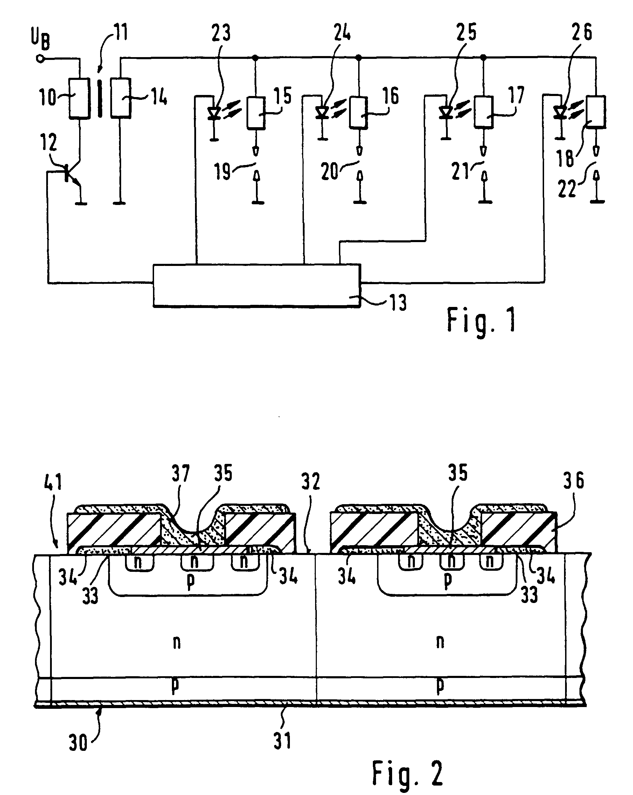

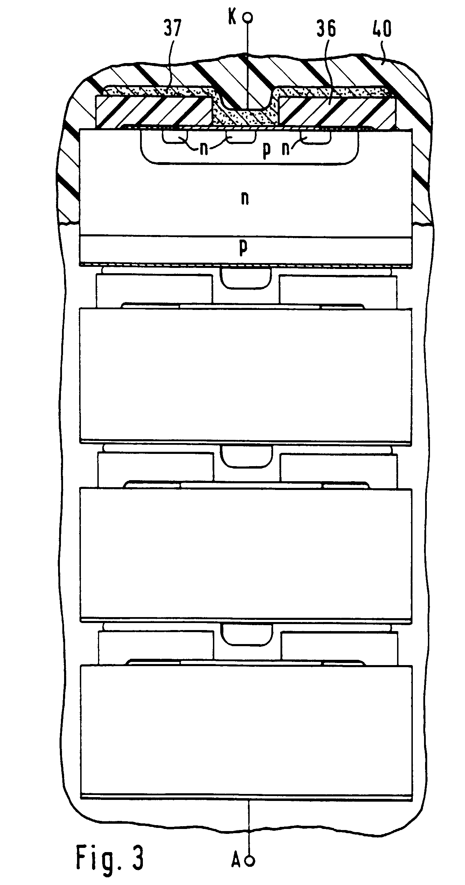

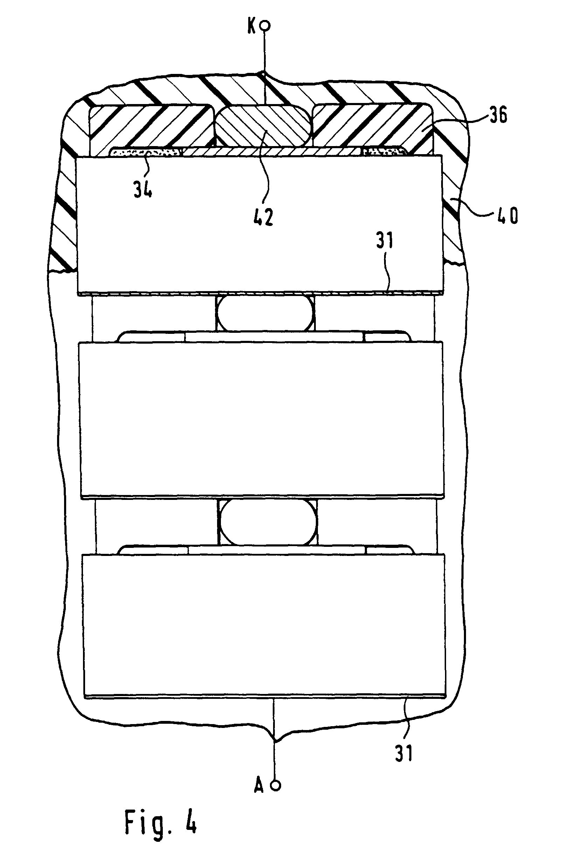

Ausführungsbeispiele der Erfindung sind in der Zeichnung dargestellt und in der nachfolgenden Beschreibung näher erläutert. Es zeigt Figur 1 den Prinzipaufbau einer Zündanlage mit der Verwendung einer Hochspannungskippdiode, Figur 2 einen Ausschnitt aus einem strukturierten Siliziumwafer mit einzelnen Kippdioden, Figur 3 die Stapelung der einzelnen Kippdioden gemäß Figur 2 mit Klebeverbindung und Figur 4 die Stapelung mit Lötverbindug.

### Beschreibung der Ausführungsbeispiele

In Figur 1 ist der Prinzipaufbau einer Zündanlage mit der Verwendung von lichtgesteuerten Hochspannungskippdioden dargestellt. Eine Batteriespannung U_{B} liegt an einer Primärwicklung 10 einer Zündspule 11, wobei die Primärwicklung 10 an der anderen Seite über einen Schalttransistor 12 mit Masse verbunden ist. Der Schalttransistor 12 wird von einer Steuerschaltung 13 über seinen Basisanschluß zur Erzeugung einer sekundärseitigen Hochspannung an der Zündspule 11 kontinuierlich betätigt. Hierfür wird beispielsweise durch die Steuerschaltung 13 aufgrund von Betriebsparametern die Schließzeit und der Zündzeitpunkt für die Zündspule bestimmt und der Basisanschluß entsprechend angesteuert. Dies ist jedoch nicht Gegenstand der Erfindung und soll nicht näher erläutert werden. Eine Sekundärwicklung 14 der Zündspule 11 liegt einerseits an Masse und ist andererseits jeweils über einer Hochspannungskippdiode 15 bis 18 mit den Zündkerzen 19 bis 22 verbunden. Die Hochspannungskippdioden 15 bis 18 ist durch die Kaskadierung einzelner Kippdiodenchips hergestellt. Den einzelnen Hochspannungskippdioden ist jeweils eine lichtemittierende Quelle 23 bis 26 beispielsweise Leuchtdioden zugeordnet. Diese Leuchtdioden werden von der Steuerung 13 entsprechend der Zündfolge angesteuert und geben so die Zündspannung an die Zündkerzen 19 bis 22 weiter. Damit ist es möglich, auch mit einer einzelnen Zündspule 11 eine ruhende Hochspannungsverteilung, d.h. ohne rotierenden Verteilerfinger zu realisieren.

Figur 2 zeigt im Querschnitt den prinzipiellen Aufbau von Kippdioden, die in Planartechnik hergestellt worden sind. Hierbei sind ausschnittsweise zwei Kippdioden, die auf einem Siliziumwafer entsprechend hergestellt sind, dargestellt. Eine einzelne Kippdiode ist beispielsweise eine Vierschichtdiode, welche aus dem Sperrzustand in den Durchlaßzustand kippt, wenn die zwischen Anode und Kathode liegende Spannung einen bestimmten Wert überschreitet. Die Kippdiode ist somit ein sehr schneller Schalter, welcher innerhalb milliardesten Sekunden aus dem hochohmigen Zustand in einen niederohmigen Zustand umschaltet. Der einzelne Kippdiodenchip besteht aus einem ca. 50 bis 600 Mikrometer dicken monokristallinen Halbleiterträger, insbesondere einem Siliziumwafer, in welchen die einzelnen Schichten (p,n,p,n) durch Diffussion von Dotierungen eingebracht sind. Hierbei ist an der Kippdiodenchipunterseite 30 eine Anodenmetallisierung 31 aufgebracht, um so die elektrischen Anschlüsse herstellen zu können. An der Kippdiodenchipoberseite 32 ist der sperrende pn-Übergang 33, welcher meist ringförmig den Kathoden-Gate-Bereich umgibt, angeordnet. Dieser hochsperrende pn-Übergang 33 ist zur Isolation mit einer Siliziumoxidschicht 34 (Sio₂) überzogen. Der Kathodenbereich ist ferner mit einer Kathodenmetallisierung 35 zur Herstellung des elektrischen Anschlusses überzogen. Bei einer einfachen Übereinanderstapelung dieser Kippdiodenchips ist die Kathodenmetallisierung der Kippdiodenchipoberseite mit der Anodenmetallisierung der Kippdiodenchipunterseite elektrisch zu verbinden, ohne daß die Siliziumoxid-Isolation 34 kurzgeschlossen wird. Hierfür ist erfindugsgemäß auf die Kippdiodenchipoberseite eine ca. 10 bis 200 Mikrometer dicke Polyimidschicht 36 aufgetragen. Diese Polyimidschicht 36 kann beispielsweise zunächst eine geschlossene Schicht über die gesamte Kippdiodenchipoberseite 32 sein, die anschließend z.B. durch einen photolitografischen Prozeß im Bereich der Kathodenanschlüsse und der Sägegräben 41 geöffnet wird. Über die gesamte Kippdiodenchipoberseite mit der Polyimidschicht wird nun ein leitfähiger Kleber 37 beispielsweise in Siebdrucktechnik aufgetragen. Dieser Kleber könnte beispielsweise ein silberhaltiger vorhärtbarer Polyimidkleber sein. Durch diesen vorgehärteten Kleber ist bei der Übereinanderstapelung eine Justierung der einzelnen Wafer zueinander möglich. Nach der Übereinanderstapelung kann der Kleber aushärten, so daß die Chips elektrisch verbunden sind und vollflächig verbundene und daher mechanisch feste Hochspannungskippdioden entstehen. Vorteilhafter Weise können aus dem Waferstapel nun eine Vielzahl von einzelenen Hochspannungskippdioden durch Trennen entlang der Sägegräben in vertikaler Richtung hergestellt werden. Letztendlich wird die jeweils am Stapelende freiliegende Kathode bzw. Anode mit einem Kopf draht versehen und die gesamte Hochspannungskippdiode mit einer lichtdurchlässigen Kunststoffumhüllung umgeben.

Figur 3 zeigt die Übereinanderstapelung der einzelnen Kippdiodenchips zu einer Hochspannungskippdiode mit der Verwendung eines leitfähigen Klebers zur Herstellung der mechanischen Verbindung und elektrischen Kontaktierung der einzelnen Kippdiodenchips untereinander. Deutlich zu erkenenn sind die auf Ober- und Unterseite angebrachten Kopfdrähte zur Herstellung des Kathoden- bzw. Anodenanschlusses. Ebenfalls angedeutet ist die durchsichtige Kunststoffumhüllung 40 der gesamten Hochspannungskippdiode.

Figur 4 zeigt eine Hochspannungskippdiode, wobei die Verbindungsschicht als eine Lotverbindung 42 realisiert ist, wobei hier sowohl Weich- als auch ein Hartlot verwendet werden kann. Im übrigen entspricht der Aufbau der Hochspannungskippdiode dem Aufbau, der bereits zu Figur 2 und 3 beschrieben wurde, so daß dies hier nicht nochmals erläutert wird.

## Patentansprüche

1. Hochspannungskippdiode mit einer Vielzahl von in Reihe geschalteten einzelnen Kippdiodenchips, wobei der hochsperrende pn-Übergang jeder einzelnen Kippdiode mit einer Isolationsschicht (34) überzogen ist, dadurch gekennzeichnet, daß die einzelnen Kippdioden in Planartechnik hergestellte Kippdiodenchips sind und sich der hochsperrende pn-Übergang (33) jeder Kippdiode auf der Kippdiodenchipoberseite (32) befindet, daß der an der Kippdiodenchipoberseite (32) liegende Kathodenbereich (K) und der an der Kippdiodenchipunterseite liegende Anodenbereich (A) mit einer elektrisch leitenden Schicht (35 bzw. 31) überzogen sind, daß auf der Kippdiodenchipoberseite eine elektrisch isolierende Kunststoffschicht (36) aufgetragen ist, welche eine Aussparung im Bereich des Kathodenbereichs aufweist und daß eine Verbindungsschicht (37), die die einzelnen Kippdiodenchips miteinander elektrisch leitend und mechanisch verbindet.

2. Hochspannungskippdiode nach Anspruch 1, dadurch gekennzeichnet, daß die elektrisch leitende Kunststoffschicht photostrukurierbar ist.

3. Hochspannungskippdiode nach Anspruch 1 oder 2, dadurch gekennzeichnet, daß die elektrisch isolierende Kunststoffschicht aus Polyimid besteht.

4. Hochspannungskippdiode nach Anspruch 3, dadurch gekennzeichnet, daß die Polyimidschicht eine Dicke von 10 bis 200 µm beträgt.

5. Hochspannungskippdiode nach einem der vorherigen Ansprüche, dadurch gekennzeichnet, daß die Verbindungsschicht ein leitfähiger Kleber ist.

6. Hochsspannungskippdiode nach Anspruch 5, dadurch gekennzeichnet, daß der Kleber ein vorhärtbarer Kleber ist.

7. Hochspannungskiopdiode nach Ansprch 5 oder 6, dadurch gekennzeichnet, daß der Kleber ein metallhaltiger Polyimidkleber ist.

8. Hochspannungskiopdiode nach einem der Ansprüche 5 bis 7, dadurch gekennzeichnet, daß der Kleber als Dickschicht im Siebdruckverfahren aufgetragen ist.

9. Hochspannungskippdiode nach einem der Ansprüche 1 bis 4, dadurch gekennzeichnet, daß die Verbindungsschicht eine Lotverbindung ist.

## Claims

1. High-voltage breakover diode having a multiplicity of series-connected individual breakover diode chips, with the pn junction, which has a high blocking capacity, of each individual breakover diode being covered with an insulation layer (34), characterized in that the individual breakover diodes are breakover diode chips produced using planar technology and the pn junction (33), which has a high blocking capacity, of each breakover diode is situated on the top (32) of the breakover diode chips, in that the cathode region (K) situated on the top (32) of the breakover diode chips and the anode region (A) situated on the underside of the breakover diode chips are covered with an electrically conductive layer (35 and 31, respectively), in that there is applied to the top of the breakover diode chips an electrically insulating plastic layer (36) which has a recess in the region of the cathode region, and in that there is provided a connecting layer (37) which electrically conductively and mechanically connects the individual breakover chips to one another.

2. High-voltage breakover diode according to Claim 1, characterized in that the electrically conductive plastic layer can be photopatterned.

3. High-voltage breakover diode according to Claim 1 or 2, characterized in that the electrically insulating plastic layer is composed of polyimide.

4. High-voltage breakover diode according to Claim 3, characterized in that the polyimide layer has a thickness of 10 to 200 µm.

5. High-voltage breakover diode according to one of the preceding claims, characterized in that the connecting layer is a conductive adhesive.

6. High-voltage breakover diode according to Claim 5, characterized in that the adhesive is a precurable adhesive.

7. High-voltage breakover diode according to Claim 5 or 6, characterized in that the adhesive is a polyimide adhesive containing metal.

8. High-voltage breakover diode according to one of Claims 5 to 7, characterized in that the adhesive is applied as a thick film using the screen printing process.

9. High-voltage breakover diode according to one of Claims 1 to 4, characterized in that the connecting layer is a soldered connection.

## Revendications

1. Diode de basculement haute tension avec un certain nombre de puces de diode de basculement individuelles montées en série, la jonction pn hautement bloquante de chacune des différentes diode de basculement étant revêtue d'une couche isolante (34),
caractérisée en ce que
- les différentes diodes de basculement sont des puces de diode de basculement fabriquées selon la technique planaire et que la jonction pn hautement bloquante (33) de chaque diode de basculement se trouve sur la face supérieure de la puce de diode de basculement (32),
- la zone cathodique (K) d'électrode, qui se trouve sur la face supérieure (32) de la puce de diode de basculement, et la zone anodique (A) d'électrode, qui se trouve sur la face inférieure de la puce de diode de basculement, sont revêtues d'une couche électriquement conductrice (35 ou 31),
- l'on dépose sur la face supérieure de la puce de diode de basculement une couche isolante électriquement de matière plastique (36), qui présente un évidement dans la zone cathodique d'électrode et
- l'on prévoit une couche de liaison (37), qui relie les différentes puces de diode de basculement les unes aux autres de façon électrique et mécanique.

2. Diode de basculement haute tension selon la revendication 1,
caractérisée en ce que
la couche de matière plastique électriquement conductrice peut être photostructurée.

3. Diode de basculement haute tension selon la revendication 1 ou 2,
caractérisée en ce que
la couche de matière plastique électriquement conductrice est réalisée en polymide.

4. Diode de basculement haute tension selon la revendication 3,
caractérisée en ce que
la couche de polymide atteint une épaisseur de 10 à 200 µm.

5. Diode de basculement haute tension selon l'une des revendications précédentes,
caractérisée en ce que
la couche de liaison est un adhésif conducteur.

6. Diode de basculement haute tension selon l'une des revendications précédentes,
caractérisée en ce que
l'adhésif est un adhésif prédurcissable.

7. Diode de basculement haute tension selon la revendication 5 ou 6,
caractérisée en ce que
l'adhésif est un adhésif en polymide contenant du métal.

8. Diode de basculement haute tension selon l'une des revendications 5 à 7,
caractérisée en ce que
l'adhésif est déposé sous la forme d'une couche épaisse par le procédé de sérigraphie.

9. Diode de basculement haute tension selon la revendication 1 à 4
caractérisée en ce que
la couche de liaison est une liaison par brasage.
